# EUROPÄISCHE PATENTSCHRIFT

(11) **EP 2 262 067 B1**
(45) Veröffentlichungstag und Bekanntmachung des Hinweises auf die Patenterteilung: **14.01.2015**
(21) Anmeldenummer: 10165590.0
(22) Anmeldetag: 10.06.2010
(51) Int. Cl.: H01S 5/32, H01S 5/20, B82Y 20/00, H01S 5/22, H01S 5/34

(54) **Optoelektronisches Halbleiterbauelement**
Optoelectronic semiconductor element
Composant semi-conducteur optoélectronique

(30) Priorität: 10.06.2009 DE 102009024945
(43) Veröffentlichungstag der Anmeldung: 15.12.2010
(73) Patentinhaber: Forschungsverbund Berlin e.V., 12489 Berlin (DE)
(72) Erfinder: Crump, Paul, 10245 Berlin (DE); Erbert, Götz, 12557 Berlin (DE); Pietrzak, Agnieszka, 10585 Berlin (DE); Wenzel, Hans, 12355 Berlin (DE); Bugge, Frank, 12555 Berlin (DE); Zorn, Martin, 12163 Berlin (DE)
(74) Vertreter: Gulde & Partner

(56) Entgegenhaltungen:
- US-A- 5 467 364
- US-A- 5 739 543
- ANDRZEJ MALAG ET AL: "Vertical Beam Divergence of Double-Barrier Multiquantum Well (DBMQW) (AlGa)As Heterostructure Lasers", JOURNAL OF LIGHTWAVE TECHNOLOGY, IEEE SERVICE CENTER, NEW YORK, NY, US, Bd. 14, Nr. 6, 1. Juni 1996 (1996-06-01), XP011028555, ISSN: 0733-8724
- GÖTZ ERBERT ET AL: "High-brightness diode lasers with very narrow vertical divergence", PROCEEDINGS OF SPIE, Bd. 6909, 1. Januar 2008 (2008-01-01), Seiten 69090P-69090P-11, XP55013314, ISSN: 0277-786X, DOI: 10.1117/12.760874
- CRUMP P ET AL: "975 nm high power diode lasers with high efficiency and narrow vertical far field enabled by low index quantum barriers", APPLIED PHYSICS LETTERS, AMERICAN INSTITUTE OF PHYSICS, US, vol. 96, no. 13, 31 March 2010 (2010-03-31), pages 131110-131110, XP012130579, ISSN: 0003-6951, DOI: 10.1063/1.3378809

## Beschreibung

Die vorliegende Erfindung betrifft ein optoelektronisches Halbleiterbauelement mit den im Anspruch 1 genannten Merkmalen, insbesondere betrifft die vorliegende Erfindung eine Hochleistungslaserdiode mit einer vorteilhaften Energieabstrahlung im Fernfeld, d.h. Abstrahlung mit einem schmalen vertikalen Fernfeld.

Generell besitzen kantenemittierende Laserdioden eine aktive Schicht, welche in Halbleiterschichten eingebettet sind, die sich durch ihre Bandlücken, Brechzahlen und Dotierung voneinander unterscheiden. Die Schichten unterhalb und oberhalb der aktiven Schicht unterscheiden sich durch den Leitungstyp (n oder p). Neben der Gewährleistung des Transports von Elektronen und Löchern zur aktiven Schicht, wo sie stimuliert rekombinieren und Laserstrahlung erzeugen, dienen diese Schichten der vertikalen Führung des Laserlichtes. Die der aktiven Schicht benachbarten Schichten werden als Wellenleiterschichten bezeichnet, die diesen Schichten benachbarten als Mantelschichten. Typischerweise ist die Brechzahl der aktiven Schicht größer als die der Wellenleiterschichten und die Brechzahl der Wellenleiterschichten größer als die der Mantelschichten. Jedoch sind auch andere Konfigurationen möglich (z.B. Vertical ARROW, Photonic Band Crystal).

Die aktive Schicht besteht bei modernen Laserdioden vorzugsweise aus Quantentrögen (Topfschichten), die durch sogenannte Barrieren (Barriereschichten) begrenzt sein können und im Falle von Multiquantentrögen durch Barrieren begrenzt sein müssen. Die Barrieren besitzen eine größere Bandlücke und somit im Allgemeinen auch eine kleinere Brechzahl als die Quantentröge. Eine weitere Variante sind Quantenpunkte oder Quantendrähte oder deren Kombination mit Quantentrögen. Die Dicke der Quantentröge und Barrieren liegt im Bereich von 1 bis 30 nm, um Quanteneffekte ausnutzen zu können.

Für eine effektive Nutzung von Hochleistungslaserdioden wird ein möglichst schmales vertikales Fernfeld benötigt, um eine größtmögliche Kopplung in optische Systeme zu erreichen. Um Diodenlaser mit schmalem vertikalen Fernfeld < 30° (volle Halbwertsbreite) zu realisieren, ist es bekannt, dass geführte Moden mit breitem Nahfeld nötig sind. Es ist aus D. Botez, APPLIED PHYSICS LETTERS VOLUME 74, NO. 21, 24 MAY 1999 bekannt, dass mit konventionellen Strukturen zwei Optionen verfügbar sind, um eine Mode mit schmalem vertikalen Fernfeld zu generieren: extrem dünne (< 0.3µm) oder extrem dicke (> 3µm) Wellenleiter. Häufig werden dicke Wellenleiter bevorzugt, weil dünne Wellenleiter mit Schichtdicken < 0.3 µm schwer reproduzierbar zu wachsen sind. Jedoch besitzen dicke Wellenleiter mit Schichtdicken > 3 µm eine Reihe von Nachteilen, beispielsweise können die optischen Verluste und der elektrische Bahnwiderstand erhöht sein. Da der elektrische Bahnwiderstand hauptsächlich durch den p-dotierten Anteil des Wellenleiters verursacht wird, kann dieser nachteilige Effekt reduziert werden, indem asymmetrische Wellenleiterschichten verwendet werden, bei denen die aktive Schicht asymmetrisch im Wellenleiter eingefügt ist, so dass die Dicke der p-leitenden Wellenleiterschicht kleiner als die Dicke der n-leitenden Wellenleiterschicht ist (sog. asymmetrischer Wellenleiter).

Ein weiterer Nachteil der Strukturen mit dicken Wellenleiterschichten ist die geringe Überlappung des optischen Feldes mit der aktiven Schicht, was zu einer Verschlechterung der Lasereigenschaften wie Schwellenstrom, Wirkungsgrad und deren Temperaturabhängigkeit führt. Um dies zumindest teilweise zu kompensieren, werden typischerweise anstelle von einem Quantentrog (nachfolgend auch Quantentopf genannt) zwei oder mehr Quantentröge in der aktiven Schicht implementiert. Die Quantentröge haben eine größere Brechzahl als Wellenleiter- und (dazwischen liegende) Barriereschichten und wirken so als ein zusätzlicher Wellenleiter, welcher das Modenprofil ändert und zu einem verbreitertem Fernfeld führt. Beispielsweise wird in breiten, asymmetrischen Strukturen die vertikale Wellenführung insofern beeinflusst, dass das vertikale Fernfeld seitliche "Schultern" bekommt, wodurch der Winkel, innerhalb dessen ein vordefinierter Teil der Strahlungsleistung (beispielsweise 95% der Strahlungsleistung) eingeschlossen ist, deutlich vergrößert wird, mit anderen Worten die emittierte Strahlung eine ungewollt größere vertikale Divergenz aufweist. Symmetrische Strukturen ergeben typischerweise ein verbreitetes Fernfeld ohne Schultern.

US 5,739,543 offenbart einen Halbleiterlaser mit einer aktiven Schicht, die eine Quantentopfstruktur aufweist, bei der mindestens eine Topfschicht und mindestens zwei Barriereschichten abwechselnd aufeinander geschichtet sind, wobei die den angrenzenden Schichten (optical confinement layer) nächstgelegenen Barriereschichten eine Brechzahl aufweisen, die kleiner oder gleich als die Brechzahl der jeweils angrenzenden optical confinement layer ist. Jedoch weist der Halbleiterlaser aufgrund der geringen Wellenleiterdicke von 400 nm eine Abstrahlung mit relativ hoher Divergenz bezogen auf das vertikale Fernfeld auf.

Malag und Mroziewicz: "Vertical Beam Divergence of Double-Barrier Mulitquantum Well (DBMQW) (AlGa)As-Heterostructure Lasers, Journal of Lightwave technologies, Bd. 14 Nr. 6, Juni 1996, bietet eine theoretische Analyse der vertikalen Strahldivergenz eines modifizierten (AlGa)As-Lasers Heterostruktur, wobei dünne Barriereschichten mit weiter Energielücke an Schnittstellen zwischen einer Multiquantentopf-Aktivregion und Mantelschichten eingefügt sind.

Erbert und andere: "High brightness diode lasers with narrow vertical divergence", Proceedings of SPIE, Vo. 6909, / Jannuar 2008, diskutiert prinzipielle Anordnungen für niedrigdivergente Diodenlaser wie einfache breite Wellenleiter und raffiniertere, resonante Wellleiter.

US 5,467,364 beschreibt einen Halbleiterlaser mit carrier block Schichten, beidseitig auf dem Äußeren eines aktive Schicht geformt, und waveguide Schichten, die beidseitig auf dem Äußeren der carrier block Schichten angeordnet sind. Weiterhin sind clad Schichten so angeordnet, dass die waveguide Schichten zwischen den clad Schichten wie in einem Sandwich liegen.

Es ist daher Aufgabe der vorliegenden Erfindung, eine Hochleistungslaserdiode anzugeben, die eine Abstrahlung mit geringer Divergenz bezogen auf das vertikale Fernfeld aufweist. Dadurch soll insbesondere eine effiziente Einkopplung der Laserstrahlung in optische Systeme, z.B. eine Lichtleitfaser, gewährleistet werden.

Durch ein geeignetes Design der aktiven Schicht sowie der Wellenleiterschichten können die Aufgaben der Erfindung gelöst werden. Dazu wird eine aktive Zone mit Quantentrögen und Barrieren vorgesehen, wobei die Zusammensetzung und die Dicke der Quantentrögen und der Barrieren geeignet ausgewählt werden. Weiterhin wird die Gesamtdicke der beiden Wellenleiterschicht geeignet gewählt.

Das erfindungsgemäße Halbleiterbauelement weist eine aktive Schicht auf, die zur Strahlungserzeugung geeignet ist, wobei die aktive Schicht eine Quantentopfstruktur aufweist, bei der mindestens eine Topfschicht und mindestens zwei Barriereschichten abwechselnd aufeinander geschichtet sind, wobei die mindestens eine Topfschicht eine Elektronenenergie aufweist, die kleiner als die Elektronenenergie der Barriereschichten ist, und wobei die jeweils den Wellenleiterschichten nächstgelegenen Barriereschichten erfindungsgemäß eine Elektronenenergie aufweisen, die höher als die Elektronenenergie der jeweils angrenzenden Wellenleiterschicht ist und wobei die Summe der Dicke der ersten Wellenleiterschicht und der zweiten Wellenleiterschicht größer als 2 µm beträgt.

Vorzugsweise weisen alle Barriereschichten eine Brechzahl auf, die (bevorzugt) kleiner (oder gleich) als die Brechzahl der jeweils angrenzenden Wellenleiterschicht ist.

Vorzugsweise beträgt die Summe der Dicke der ersten Wellenleiterschicht und der zweiten Wellenleiterschicht größer als 3 µm. Vorzugsweise beträgt die Summe der Dicke der ersten Wellenleiterschicht und der zweiten Wellenleiterschicht größer als 4 µm. Vorzugsweise beträgt die Summe der Dicke der ersten Wellenleiterschicht und der zweiten Wellenleiterschicht größer als 5 µm. Vorzugsweise beträgt die Summe der Dicke der ersten Wellenleiterschicht und der zweiten Wellenleiterschicht größer als 6 µm.

Vorzugsweise beträgt die Summe der Dicke der ersten Wellenleiterschicht und der zweiten Wellenleiterschicht kleiner als 10 µm. Vorzugsweise beträgt die Summe der Dicke der ersten Wellenleiterschicht und der zweiten Wellenleiterschicht kleiner als 8 µm.

Besonders bevorzugt beträgt die Summe der Dicke der ersten Wellenleiterschicht und der zweiten Wellenleiterschicht zwischen 2 und 6 µm. Weitere bevorzugte Intervalle sind 2-3 µm, 3-4 µm, 4-5 µm und 5-6 µm. Abhängig von der Vorgabe kann das Spannungsverhältnis zwischen geringen optischen Verlusten und einem geringen elektrischem Bahnwiderstand (erfordert eine geringe Gesamtwellenleiterdicke) einerseits und einer geringen Fernfelddivergenz (erfordert eine große Gesamtwellenleiterdicke) andererseits in den genannten Intervallen optimal gestaltet werden, wobei stets die Barriereschichten eine Brechzahl aufweisen, die bevorzugt kleiner oder gleich als die Brechzahl der jeweils angrenzenden Wellenleiterschicht ist.

Es wurde gefunden, dass eine Abstrahlung mit relativ geringer Divergenz bezogen auf das vertikale Fernfeld erreicht werden kann, wenn ein Halbleiterbauelement eine relativ hohe Gesamtwellenleiterdicke sowie eine Quantentopfstruktur aufweist, bei der die jeweils den Wellenleiterschichten nächstgelegenen Barriereschichten eine Elektronenenergie aufweisen, die höher als die Elektronenenergie der jeweils angrenzenden Wellenleiterschicht ist. Insbesondere wurde gefunden, dass entsprechende Quantentopfstrukturen erst ab einer bestimmten Gesamtwellenleiterdicke zu einer Verringerung der Fernfelddivergenz führen. Um die allgemein bekannten Nachteile eines dicken Wellenleiters (optischen Verluste und der elektrische Bahnwiderstand) weiter zu kompensieren, ist es bevorzugt, asymmetrische Wellenleiterschichten zu verwenden, bei denen die aktive Schicht asymmetrisch im Wellenleiter eingefügt ist, so dass die Dicke der p-leitenden Wellenleiterschicht kleiner als die Dicke der n-leitenden Wellenleiterschicht ist. Dadurch kann der elektrische Bahnwiderstand, der hauptsächlich durch den p-dotierten Anteil des Wellenleiters verursacht wird, weiter verringert werden. Alternativ ist es auch möglich, dass die die Dicke der n-leitenden Wellenleiterschicht kleiner als die Dicke der p-leitenden Wellenleiterschicht ist.

Vorzugsweise weisen die jeweils nächstgelegenen Barriereschichten eine Schichtdicke von kleiner als 25nm, bevorzugter kleiner als 15 nm, noch bevorzugter kleiner als 12 nm und noch bevorzugter kleiner als 8 nm auf, wodurch die (die Quantentröge einschließenden) Barrieren die relativ hohe Brechzahl der Quantentröge zumindest teilweise kompensieren. Dadurch kann mehr Energie unter einem geringen Winkel (bezogen auf das Fernfeld) abgestrahlt werden. Vorzugsweise sind die Schichtdicke der mindestens einen Topfschicht und/oder die Schichtdicke der mindestens zwei Barriereschichten homogen. Vorzugsweise sind die Schichtdicke der mindestens einen Topfschicht und der mindestens zwei Barriereschichten gleich groß. Vorzugsweise beträgt die Schichtdicke der mindestens einen Topfschicht zwischen 1-25 nm, bevorzugter zwischen 5-20 nm. Vorzugsweise sind die Schichtdicken der mindestens einen Topfschicht uniform und gleich. Vorzugsweise sind die Schichtdicken der mindestens zwei Barriereschichten uniform und gleich.

Vorzugsweise ist ein Rippenwellenleiter im Bereich der zweiten Wellenleiterschicht und der zweiten Mantelschicht vorgesehen. Vorzugsweise beträgt das Verhältnis der Dicke der ersten Wellenleiterschicht zur Dicke der zweiten Wellenleiterschicht zwischen 1.5 und 10, bevorzugt zwischen 2 und 5. Vorzugsweise beträgt die Breite des Rippenwellenleiters größer 2 µm, bevorzugt größer als 4 µm.

Eine bevorzugte Variante ist die Verwendung von Barrieren aus GaAsP mit Phosphorgehalten größer 20 % zur Einbettung von InGaAs - Quantentrögen. Da die Dicke dieser Barrieren hinreichend klein ist, können die Barrieren auch hochverspannt sein. Eine weitere bevorzugte Ausführungsform ist die Verwendung von schwachverspannten AlGaAs-Barrieren mit geeignetem Aluminium-Gehalt (>= 40 %) zur Einbettung von GaAsP-Quantentrögen. Ein weiteres bevorzugtes Barrierenmaterial ist InGaP. Generell sind alle Verbindungshalbleiter bestehend aus den Elementen der Hauptgruppe 3 (AI, Ga, In) und den Elementen der Hauptgruppe 5 (N, P, As, Sb) des Periodensystems geeignet.

Die Ursache für das Entstehen der unerwünschten Verbreitung des Fernfelds (z.B. als Schultern in asymmetrischer Strukturen) besteht darin, dass die Quantentröge eine größere Brechzahl als die Wellenleiterschichten besitzen, so dass die aktive Schicht selbst als Wellenleiter wirkt (besonders bei einer Vergrößerung der Zahl der Quantentröge). Das neue Design besteht darin, die Zusammensetzung des Verbindungshalbleiters und die Dicke der die Quantentröge einschließenden Barrieren so zu wählen, dass die große Brechzahl der Quantentröge zumindest teilweise kompensiert wird.

Herkömmlicherweise dienen die Barrieren lediglich dazu, die Quantentröge voneinander zu separieren und die Ladungsträger (Elektronen und Löcher) in den Quantentrögen einzuschließen. Der grundlegende Gedanke der Erfindung betrifft jedoch eine neue, zusätzliche Funktion der Barrieren, nämlich die Kompensation der hohen Brechzahlen der Quantentröge, insbesondere soll die Brechzahl der Barriereschichten niedriger sein als die Brechzahl der angrenzenden Weflenfeiterschichten.

Die Quantentröge weisen vorzugsweise eine Brechzahl auf, die zwischen 0.05 - 0.7 (bevorzugter zwischen 0.15 - 0.6, noch bevorzugter mindestens 0.2 - 0.4) größer als die Brechzahl des angrenzenden Wellenleiters bezogen auf die Emissionswellenlänge der aktiven Schicht ist. Die Barriereschichten weisen vorzugsweise eine Brechzahl auf, die zwischen 0.01 und 0.4 (bevorzugter zwischen 0.05 und 0.3 und noch bevorzugter zwischen 0.1 und 0.25) kleiner als die Brechzahl der angrenzenden Wellenleiterschichten bezogen auf die Wellenlänge der durch die aktive Schicht emittierten elektromagnetischen Strahlung ist. Die Brechzahl des Wellenleiters liegt vorzugsweise im Bereich 3.25 bis 3.55, und die Brechzahl der Quantentröge liegt vorzugsweise im Bereich 3.4 bis 3.8.

Die von der aktiven Schicht emittierte elektromagnetische Strahlung weist vorzugsweise eine Zentralwellenlänge zwischen 200 nm bis 12 µm, bevorzugter 280 nm bis 1600 nm, und noch bevorzugter zwischen 600 nm bis 1100 nm auf.

Als Barriereschichten werden sämtliche, die Quantentröge voneinander separierenden Schichten verstanden, wobei die Quantentröge (auch Topfschichten genannt) die eigentliche Emission realisieren. Vorzugsweise kann beim erfindungsgemäßen Halbleiterbauelement auf weitere, im Wellenleiter oder in den Mantelschichten integrierte Zusatzschichten mit zum Wellenleiter/zur Mantelschicht unterschiedlichen Brechzahlen verzichtet werden, wodurch die Fertigungskosten verringert werden können, da eine Brechzahlkompensation direkt durch die Barriereschichten bei gleichzeitig relativ dünnen Wellenleiterschichten erreicht werden kann. Mit anderen Worten können die Wellenleiterschichten/Mantelschichten der vorliegenden Erfindung jeweils mit homogener Brechzahl/Schichtdicke über ihre gesamte Schichtdicke verwendet werden. Vorzugsweise kontaktieren die Wellenleiterschichten direkt die aktive Schicht und die Mantelschichten kontaktieren direkt die Wellenleiterschichten, ohne dass dazwischen weitere Schichten zur Kompensation der Brechzahl angeordnet sind.

Vorzugsweise weist die von der aktiven Schicht emittierte elektromagnetische Strahlung eine Zentralwellenlänge zwischen 1,24 µm bis 0.59 µm auf.

Vorzugsweise sind die aktive Schicht, die erste Wellenleiterschicht, die zweite Wellenleiterschicht, die erste Mantelschicht und die zweite Mantelschicht jeweils als halbleitende Schichten ausgebildet, wobei sich der Leitungstyp der ersten Wellenleiterschicht und der ersten Mantelschicht vom Leitungstyp der zweiten Wellenleiterschicht und der zweiten Mantelschicht unterscheidet. Vorzugsweise ist die aktive Schicht asymmetrisch innerhalb der Wellenleiterschichten angeordnet.

Vorzugsweise weist die Quantentopfstruktur zwischen 1 und 20 Topfschichten, bevorzugt zwischen 1 und 10 Topfschichten und noch bevorzugter zwischen 1 und 6 Topfschichten auf. Vorzugsweise bestehen sämtliche Schichten der aktiven Schicht aus jeweils einem Verbindungshalbleiter.

Vorzugsweise enthält die Topfschicht und/oder die Barriereschichten einen Verbindungshalbleiter mit dem Element Phosphor, wobei der Phosphorgehalt der mindestens einen Topfschicht geringer als der Phosphorgehalt der mindestens zwei Barriereschichten ist. Vorzugsweise enthält die Topfschicht und/oder die Barriereschichten einen Verbindungshalbleiter mit dem Element Aluminium, wobei der Aluminiumgehalt der mindestens einen Topfschicht geringer als der Aluminiumgehalt der mindestens zwei Barriereschichten ist. Vorzugsweise ist der Unterschied in den Elementanteilen der mindestens zwei Barriereschichten größer als 0.2, bevorzugter größer als 0.3, noch bevorzugter größer als 0.4 und noch bevorzugter größer als 0.5.

Vorzugsweise weist die mindestens eine Topfschicht eine Elektronenenergie unterhalb eines ersten Grenzwerts und die Barriereschichten eine Elektronenenergie oberhalb eines zweiten Grenzwerts auf, wobei der erste Grenzwert kleiner als der zweite Grenzwert ist.

Vorzugsweise ist die Breite des Rippenwellenleiters in Abhängigkeit von der Dicke der Wellenleiterschichten gewählt.

Die vorliegende Erfindung offenbart weiterhin ein Verfahren zur Herstellung eines optoelektronischen Halbleiterbauelements mit mindestens einem der vorgenannten Merkmale, mit folgenden Verfahrensschritten: Aufbringen einer ersten Mantelschicht auf ein Substrat, Aufbringen einer ersten Wellenleiterschicht auf die erste Mantelschicht, Aufbringen einer aktiven Schicht, die zur Strahlungserzeugung geeignet ist, auf die erste Wellenleiterschicht, Aufbringen einer zweiten Wellenleiterschicht auf die aktive Schicht und Aufbringen einer zweiten Mantelschicht auf die zweite Wellenleiterschicht, wobei die aktive Schicht mit einer Quantentopfstruktur ausgebildet wird, die mindestens eine Topfschicht und mindestens zwei Barriereschichten, die jeweils abwechselnd aufeinander geschichtet sind, aufweist, wobei die mindestens eine Topfschicht eine Elektronenenergie aufweist, die kleiner als die Elektronenenergie der Barriereschichten ist, wobei die jeweils der ersten Wellenleiterschicht und der zweiten Wellenleiterschicht nächstgelegenen Barriereschichten mit einer Elektronenenergie ausgebildet wird, die höher als die Elektronenenergie der jeweils angrenzenden Wellenleiterschicht ist und wobei die erste Wellenleiterschicht und die zweite Wellenleiterschicht derart ausgebildet werden, dass die Summe der Dicke der ersten Wellenleiterschicht und der zweiten Wellenleiterschicht größer als 2 µm beträgt.

Dieses Verfahren wird erfindungsgemäß zur Herstellung eines optoelektronischen Halbleiterbauelements nach allen Varianten der vorliegenden Erfindung eingesetzt.

Die Erfindung wird nachfolgend anhand von Ausführungsbeispielen näher erläutert. Es zeigen:
- Fig. 1: eine herkömmliche Halbleiter-Laserdiodenstruktur sowie das Profil der Brechzahl und der Bandlücke der einzelnen Schichten der herkömmlichen Hafbleiter-Laserdiodenstrukfiur,
- Fig. 2: die simulierte Intensitätsverteilung der Strahlung der in Fig. 1 gezeigten Laserdiode im Fernfeld (5 cm Entfernung von der Austrittsfacette),
- Fig. 3a: eine Halbleiter-Laserdiodenstruktur nach einer ersten Ausführungsvariante der Erfindung sowie das Profil der Brechzahl und der Bandlücke der einzelnen Schichten der erfindungsgemäßen Halbleiter-Laserdiodenstruktur,
- Fig. 3b: eine Halbleiter-Laserdiodenstruktur nach einer zweiten Ausführungsvariante der Erfindung sowie das Profil der Brechzahl und der Bandlücke der einzelnen Schichten der erfindungsgemäßen Halbleiter-Laserdiodenstruktur,
- Fig. 3c: eine Halbleiter-Laserdiodenstruktur nach einer dritten Ausführungsvariante der Erfindung sowie das Profil der Brechzahl und der Bandlücke der einzelnen Schichten der erfindungsgemäßen Halbleiter-Laserdiodenstruktur,
- Fig. 4: die simulierte Intensitätsverteilung der Strahlung der in Fig. 3a gezeigten Laserdiode im Fernfeld bei 5 cm Entfernung von der Austrittsfacette,
- Fig. 5: einen Vergleich der gemessenen Intensitätsverteilung der Strahlung einer erfindungsgemäßen Laserdiode (gestrichelte Linie) und einer herkömmlichen Laserdiode (durchgezogene Linie) im Fernfeld bei 5 cm Entfernung von der Austrittsfacette,
- Fig. 6: einen Vergleich herkömmlicher Laserdioden (Dreieck) und einer erfindungsgemäßen Laserdiode (Quadrat) bezüglich der gemessenen externen Quanteneffizienz als Funktion des vertikalen Fernfeldes,
- Fig. 7.: den schematischen Querschnitt durch einen herkömmlichen Laser mit Rippenwellenleiter sowie die Intensitätsverteilungen der dazugehörigen Grundmode und der lateralen Mode 1. Ordnung,
- Fig. 8: den schematischen Querschnitt durch einen erfindungsgemäßen Laser mit Rippenwellenleiter sowie die Intensitätsverteilungen der dazugehörigen Grundmode und der lateralen Mode 1. Ordnung,
- Fig. 9: die Abhängigkeit der Fernfelddivergenz von der Gesamtwellenleiterdicke (Summe der Dicke von erstem Wellenleiter und zweitem Wellenleiter) für eine herkömmliche Quantentrogstruktur und eine erfindungsgemäße Quantentrogstruktur.

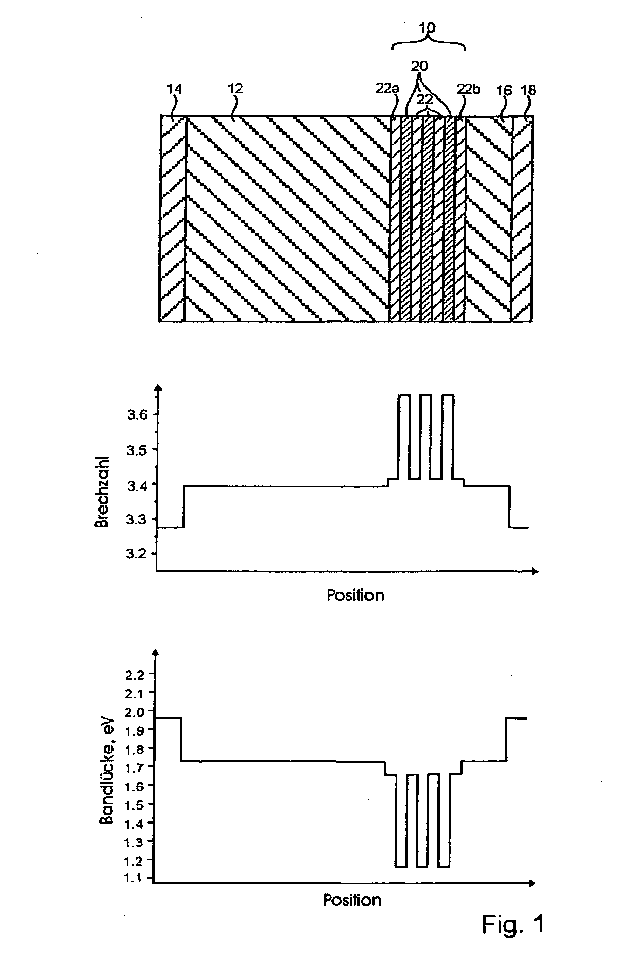

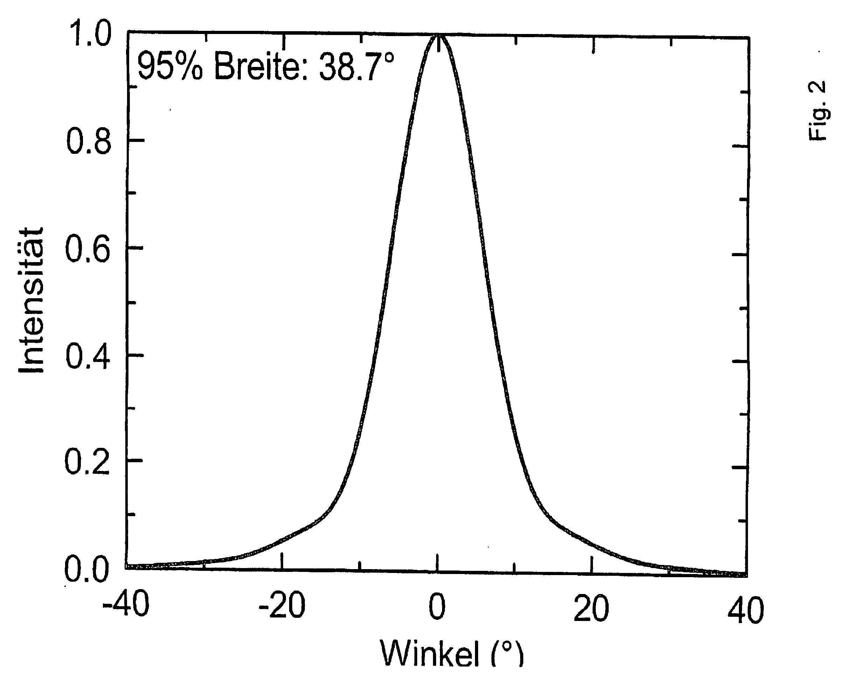

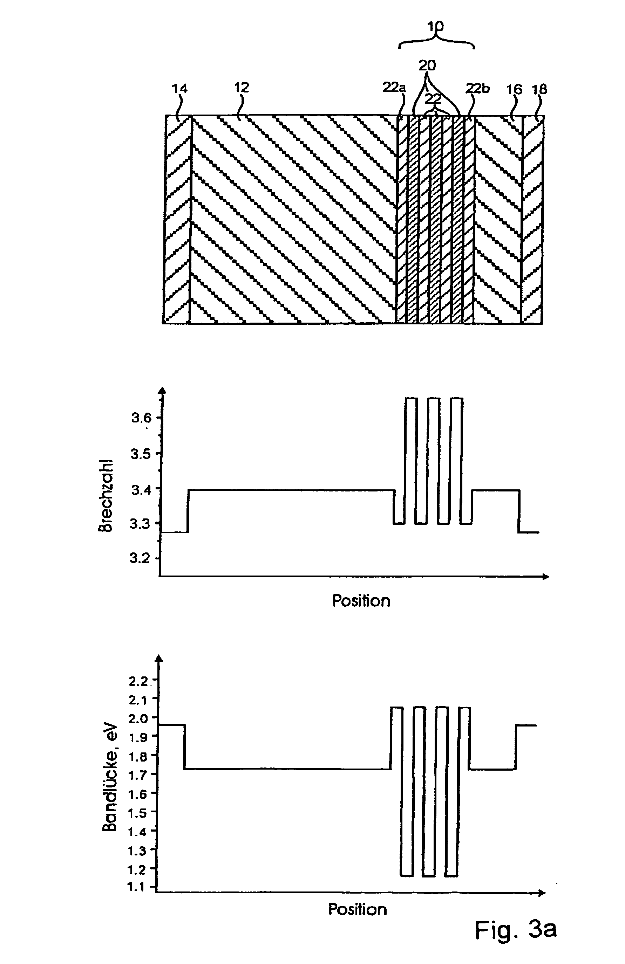

Fig. 1 zeigt eine herkömmliche Halbleiter-Laserdiodenstruktur, die auf einer Zentralwellenlänge von 975 nm emittiert. Fig. 1 zeigt weiterhin in der Mitte und unten das Profil der Brechzahl und der Bandlücke entlang der in der Fig. 1 oben dargestellten Schichten. Die Werte von Brechzahl und Bandlücke in der Mitte und unten sind jeweils den exakt darüber dargestellten Schichten (Fig. 3a-3c analog) zugeordnet. Fig. 2 zeigt die Intensitätsverteilung der Transversal-Grundmode im Fernfeld bei einer Entfernung von 5 cm von der Austrittsfacette. Die Halbleiter-Laserdiodenstruktur nach Fig. 1 weist druckverspannte InGaAs-Quantentröge 20 auf, welche in zugverspannte GaAs(0.8)P(0.2) - Barrierenschichten 22, 22a, 22b eingebettet werden. Die n-seitige Mantelschicht wurde aus Al(0,4)Ga(0,6)As, der Wellenleiter aus Al(0,2)Ga(0,8)As und die p-seitige Mantelschicht aus Al(0,4)Ga(0,6)As hergestellt.

Ein relativ dicker Wellenleiter gibt ein kleines vertikales Fernfeld (14° volle Halbwertsbreite), aber der schnelle Abfall der Lichtintensität im Wellenleiter ergibt Schultern im Fernfeld und somit einen großen Fernfeldwinkel. Daher ist der Fernfeldwinkel für den gewählten Schichtaufbau, innerhalb dessen 95 % der Strahlungsleistung eingeschlossen ist, mit 38,7° deutlich vergrößert (Fig. 2). Die ungewollte Verbreiterung der Divergenz der emittierten Strahlung im Fernfeld wird insbesondere durch die Ausbildung sogenannter Schultern 24 hervorgerufen, weil die Quantentröge eine größere Brechzahl (Fig. 1, Mitte) als die Wellenleiterschichten besitzen, so dass bei einer Vergrößerung der Zahl der Quantentröge die aktive Schicht selbst als Wellenleiter wirkt.

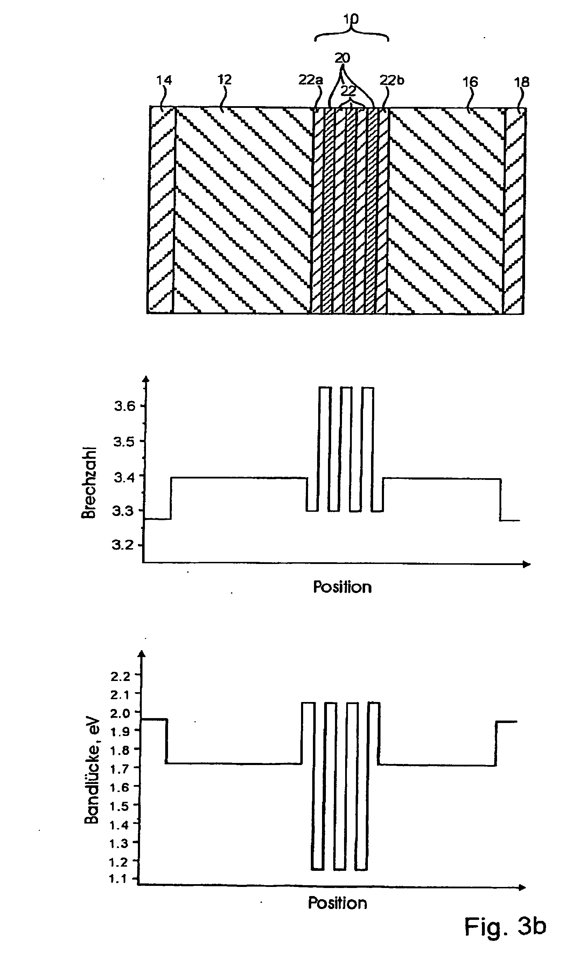

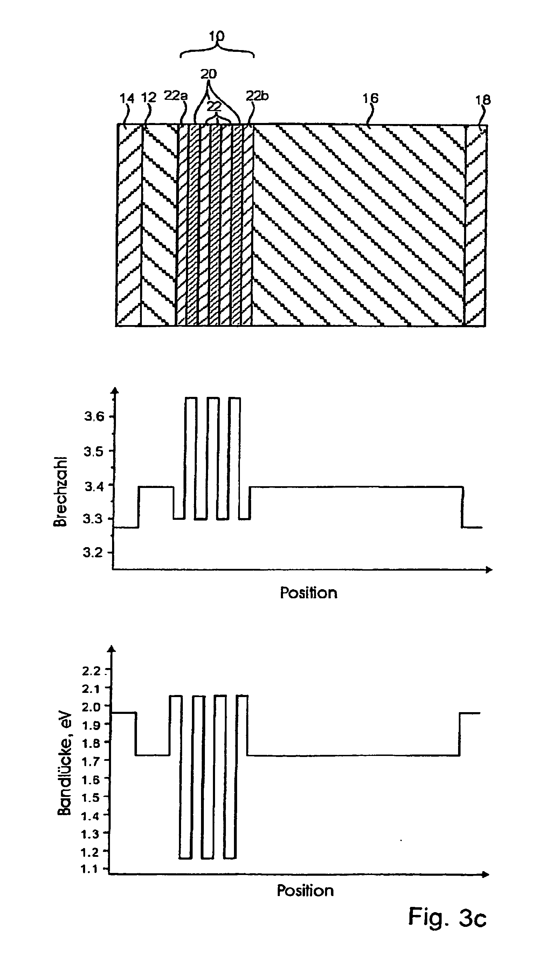

Dies wird erfindungsgemäß dadurch vermieden, dass die Barriereschichten 22, 22a, 22b eine geringere Brechzahl als die Wellenleiterschichten 12, 16 aufweisen (Fig. 3a, 3b und 3c). Die Barriereschichten 22, 22a, 22b dienen also nicht nur dazu, die Quantentröge 20 voneinander zu separieren und die Ladungsträger (Elektronen und Löcher) in den Quantentrögen einzuschließen, sondern weiterhin dazu, eine Kompensation der hohen Brechzahlen der Quantentröge 20 zu realisieren, insbesondere soll die Brechzahl der Barriereschichten 22, 22a, 22b niedriger sein als die Brechzahl der angrenzenden Wellenleiterschichten 12, 16. Die aktive Schicht 10 mit ihrer erfindungsgemäßen Quantentopfstruktur 20, 22, 22a, 22b kann in unterschiedlichen Symmetrien zu den elektrischen Kontakten (Fig. 3a und 3c: asymmetrisch zum n-Kontakt/p-Kontakt hin bzw. Fig. 3b: symmetrisch) angeordnet sein, besonders bevorzugt asymmetrisch zum p-Kontakt hin.

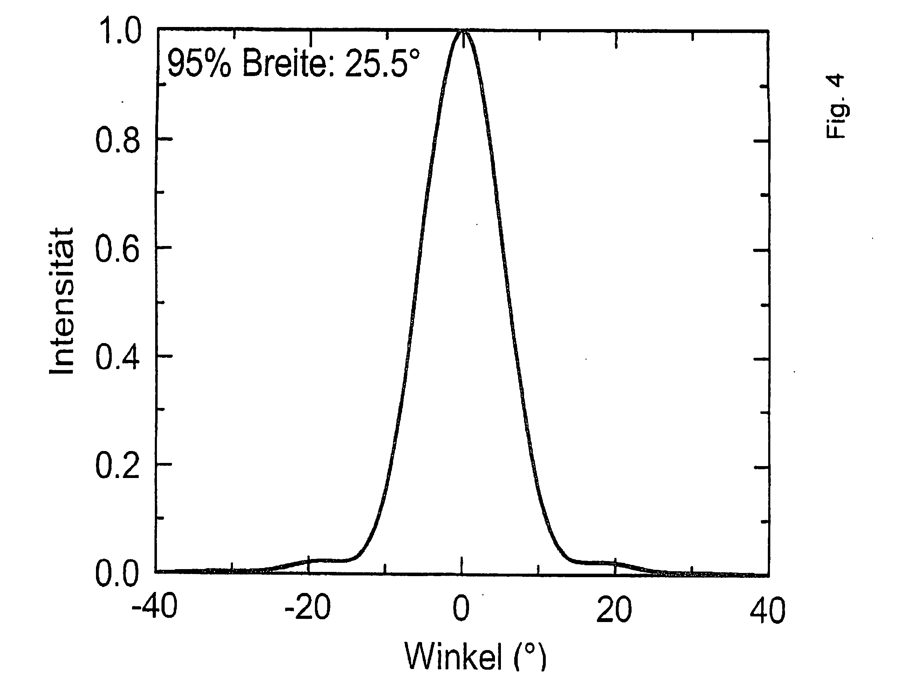

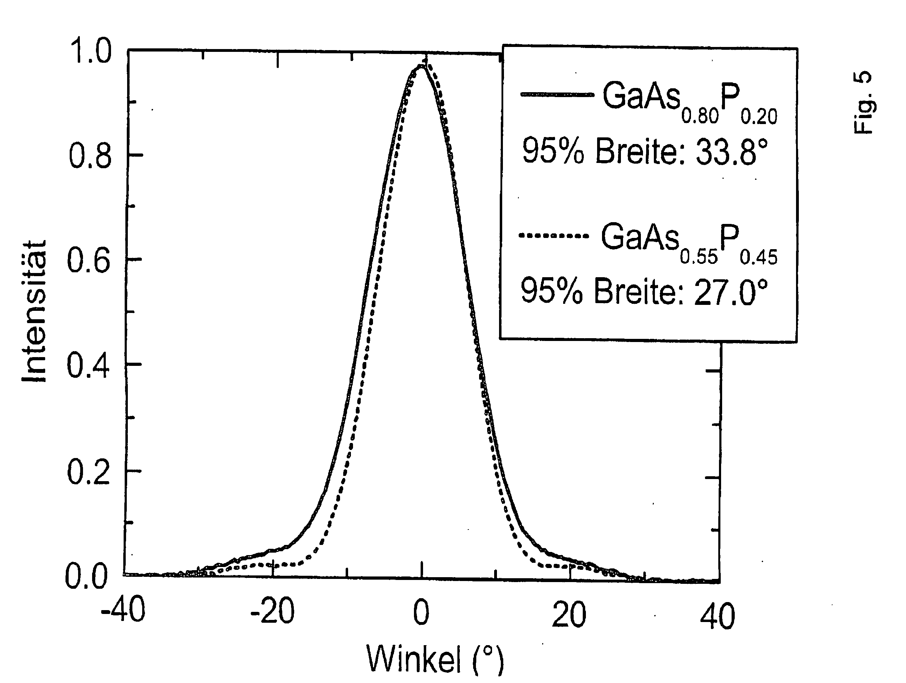

Wird beispielsweise der Phosphorgehalt der Barriereschichten 22, 22a, 22b der herkömmlichen Struktur der Fig. 1 erhöht (beispielsweise von 0.2 auf 0.45), steigt die Bandlücke an und somit nimmt die Brechzahl der Barriereschichten 22, 22a, 22b ab (Fig. 3a-3c). Die Reduzierung der Brechzahl der Barriereschichten 22, 22a, 22b kompensiert dann die hohe Brechzahl der Quantentröge 20. Dadurch ergibt sich ein nicht so starker Abfall der Intensität der geführten Mode von der aktiven Schicht weg und eine Reduktion der Fernfeldschultern. Dadurch kann der Fernfeldwinkel, innerhalb dessen 95 % der Strahlungsleistung eingeschlossen ist, auf 25,5° reduziert werden (Fig. 4 und 5). Diese erfindungsgemäßen Laserdioden sind transversalelektrisch polarisiert (wegen der Druckverspannung der Quantentröge 20).

Ein weiteres bevorzugtes Ausführungsbeispiel sind Laserdioden im Wellenlängenbereich von 730nm bis 810nm. Dort bestehen die Quantentröge herkömmlicherweise aus zugverspanntem GaAsP, welche in nahezu gitterangepasste Al(0.3)Ga(0.7)As-Barrieren eingebettet werden. Durch Erhöhung des Al-Gehaltes nimmt die Bandlücke der Barriereschichten zu und somit die Brechzahl der Barriereschichten ab, sodass wiederum die hohe Brechzahl der Quantentröge kompensiert wird. Diese Laserdioden sind transversal-magnetisch polarisiert (wegen der Zugverspannung in den Quantentrögen).

Andere Barrierenmaterialien wie vorzugsweise InGaP können den gleichen Effekt ergeben. Dadurch können kleinere Fernfeldwinkel für eine vordefinierte Wellenleiterschichtdicke erreicht werden.

Fig. 5 zeigt den Vergleich der Intensitätsverteilung der Strahlung einer erfindungsgemäßen Laserdiode und einer herkömmlichen Laserdiode im Fernfeld.

Zwei an sich identische Laserdioden mit einer Wellenlänge von 975 nm wurden hergestellt, wobei eine herkömmliche Laserdiode (in Fig. 5: durchgezogene Linie) konventionelle GaAs(0.8)P(0.2) Barriereschichten nutzt. Die erfindungsgemäße Laserdiode wurde derart modifiziert, dass die GaAs(0.8)P(0.2) Barriereschichten durch GaAs(0,55)P(0,45) Barriereschichten ersetzt wurden. Fig. 5 zeigt die gemessene (vertikale) Fernfeidverteilung. Die erfindungsgemäße Laserdiode weist einen um 7° reduzierten vertikalen Fernfeldwinkel (95 % Leistungseinschluss) auf.

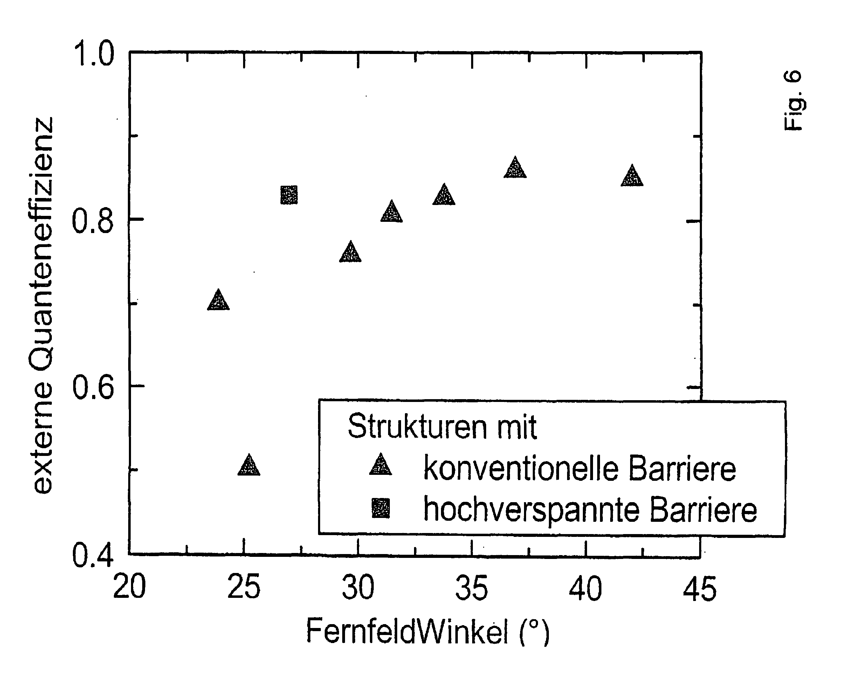

Fig. 6 zeigt die externe Quanten-Effizienz (Anstieg geteilt durch Photonen-Energie in eV) als Funktion des vertikalen Fernfeldwinkels (95 % Leistungseinschluss) für sieben unterschiedliche, herkömmliche Laserdioden (als Quadrat dargestellt) mit einer Wellenlänge 975 nm und einer erfindungsgemäßen Laserdiode mit Barriereschichten mit erhöhten Phosphorgehalt (als Dreieck dargestellt). Die optimierten Barrieren der erfindungsgemäßen Laserdiode erlauben die Nutzung eines dünneren Wellenleiters für einen bestimmten Fernfeldwinkel, wodurch sich verbesserte optische Eigenschaften ergeben.

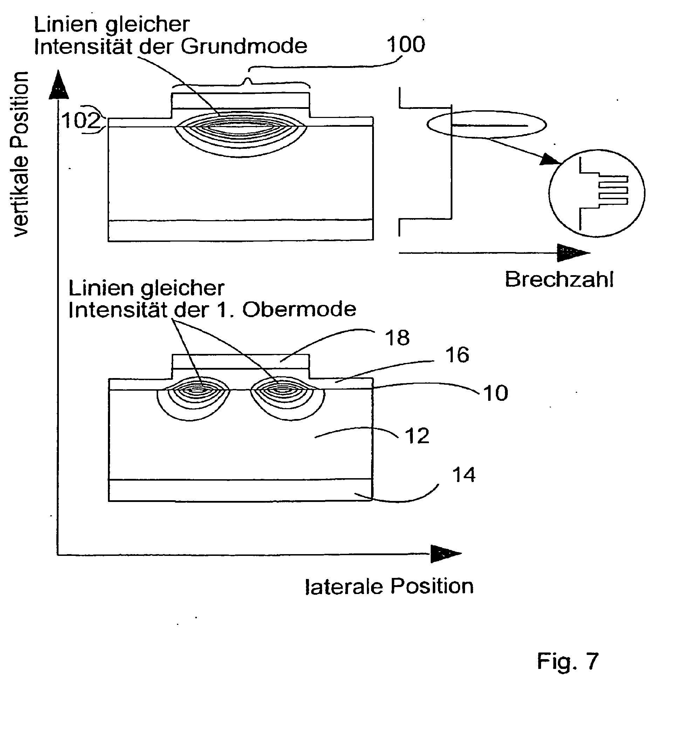

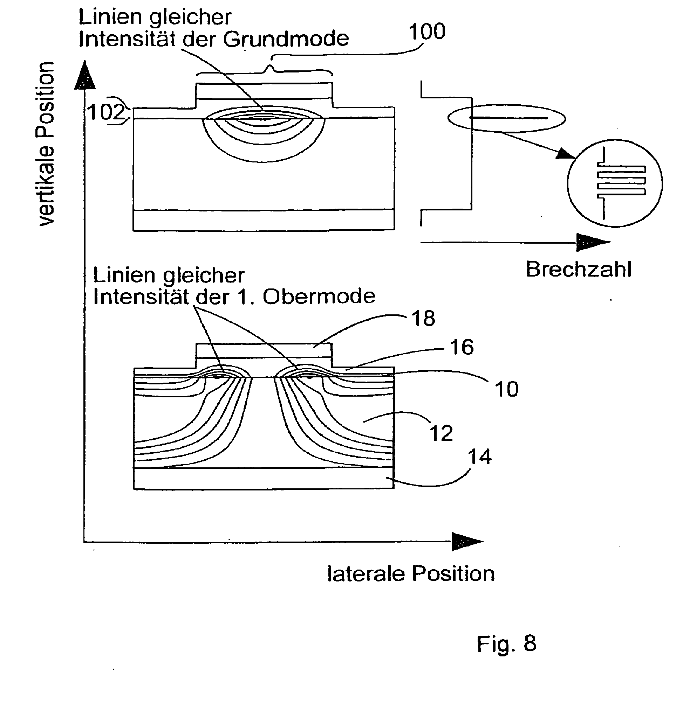

Durch eine Optimierung der Brechzahl der Barrieren der aktiven Schicht lässt sich auch die laterale Wellenleitung beeinflussen. Typischerweise soll durch eine laterale Wellenleitung erreicht werden, dass möglichst wenige laterale Moden die Laserschwelle erreichen, im Idealfall nur die laterale Mode niedrigster Ordnung (die Grundmode) und keine laterale Moden höherer Ordnung. Das Lasern mehrerer lateraler Moden führt im Allgemeinen zu einer Verschlechterung der lateralen Strahlqualität und damit lässt sich der Laserstrahl schlechter fokussieren und in optische Systeme einkoppeln. Eine laterale Wellenleitung kann z.B. durch das Wegätzen eines Teils der Halbleiterschichten seitlich des stromführenden Kontaktstreifens erreicht werden. Dadurch wird ein sogenannter Rippenwellenleiter 100 (Fig. 7 und 8) erzeugt. Die Dicke der seitlich des stromführenden Bereiches nicht geätzten Halbleiterschichten ist die Restschichtdicke 102.

Damit nur die laterale Grundmode die Laserschwelle erreicht, muss die Breite des Rippenwellenleiters 100 hinreichend klein gewählt werden. In Abhängigkeit von Wellenlänge, Schichtstruktur und Restschichtdicke 102 beträgt diese Breite bei einer konventionellen aktiven Zone (Fig. 7) typischerweise 1 bis 3 Mikrometer. Die Restschichtdicke liegt vorzugsweise im Bereich zwischen 0 µm und 1 µm, noch bevorzugter zwischen 0.1 µm und 0.5 µm. Da die Ausgangleistung proportional zur Breite der Intensitätsverteilung der Mode ist und diese wiederum im Wesentlichen durch die Breite des Rippenwellenleiters 100 gegeben ist, ist die maximale Ausgangsleistung derartiger Laser auf 100 mW bis 500 mW beschränkt. Um größere Ausgangsleistungen zu erreichen, muss die Breite des Rippenwellenleiters 100 auf Werte größer 3 Mikrometer erhöht werden. Damit können jedoch laterale Moden höherer Ordnung die Laserschwelle erreichen und die Strahlqualität verschlechtert sich.

Durch das Design der aktiven Schicht und insbesondere die Wahl des Barrierenmaterials kann jedoch erreicht werden, dass die Überlappung der Intensitätsverteilung lateraler Moden höherer Ordnung mit der aktiven Schicht 10 sich verringert und somit das Erreichen der Laserschwelle dieser Moden erschwert wird.

Fig. 7 zeigt den schematischen Querschnitt durch einen Laser mit einer herkömmlichen Schichtstruktur sowie die Intensitätsverteilungen der Grundmode und der lateralen Mode 1. Ordnung. Fig. 8 zeigt den schematischen Querschnitt durch einen Laser mit erfindungsgemäßen der Schichtstruktur (Quantentopfstruktur) sowie die Intensitätsverteilungen der Grundmode und der lateralen Mode 1. Ordnung einer Schichtstruktur mit der neuen aktiven Schicht mit Barrieren mit reduzierter Brechzahl. Die Intensitätsverteilungen wurden mit einem zweidimensionalen skalaren Modenberechnungsprogramm erhalten. Sowohl die Intensität der Grundmode als auch die der 1. Obermode sind im Bereich des Rippenwellenleiters 100 und der aktiven Schicht 10 lokalisiert (Fig. 7). Damit können beide Moden die Laserschwelle erreichen.

Während die Intensität der Grundmode weiterhin im Bereich des Rippenwellenleiters 100 und der aktiven Schicht 10 lokalisiert sind, verteilt sich ein großer Teil der Intensität der 1. Obermode außerhalb des Rippenwellenleiters 100 und in der 1. Wellenleiterschicht 12 (Fig. 8). Daher kann die 1. Obermode die Laserschwelle nicht mehr erreichen.

Besonders vorteilhaft ist die Wirkung des Rippenwellenleiters in Kombination mit den neuen Barrierenschichten für sehr breite Wellenleiter mit Dicken größer 0.5 Mikrometer, noch bevorzugter größer 3 Mikrometer. Erfindungsgemäß ist die Gesamtdicke der Wellenleiter größer 2 µm. Noch vorteilhafter ist die Wirkung, wenn die aktive Schicht asymmetrisch innerhalb der Wellenleiterschichten angeordnet, wobei die Dicke der zweiten Wellenleiterschicht 16 kleiner als die Dicke der ersten Wellenleiterschicht 12, zum Beispiel die Dicke der ersten Wellenleitersicht 12 gleich 3 Mikrometer und Dicke der zweiten Wellenleiterschicht 16 gleich 1 Mikrometer ist. Dies erlaubt, die Breite des Rippenwellenleiters 100 auf Werte größer 4 Mikrometer zu erhöhen ohne das laterale Obermoden die Laserschwellen erreichen.

Vorzugsweise ist die Breite des Rippenwellenleiters in Abhängigkeit von der Dicke der Wellenleiterschichten gewählt. Besonders bevorzugt beträgt die Breite des Rippenwellenleiters gleich oder größer der Summe der Dicke von erster Wellenleiterschicht und zweiter Wellenleiterschicht.

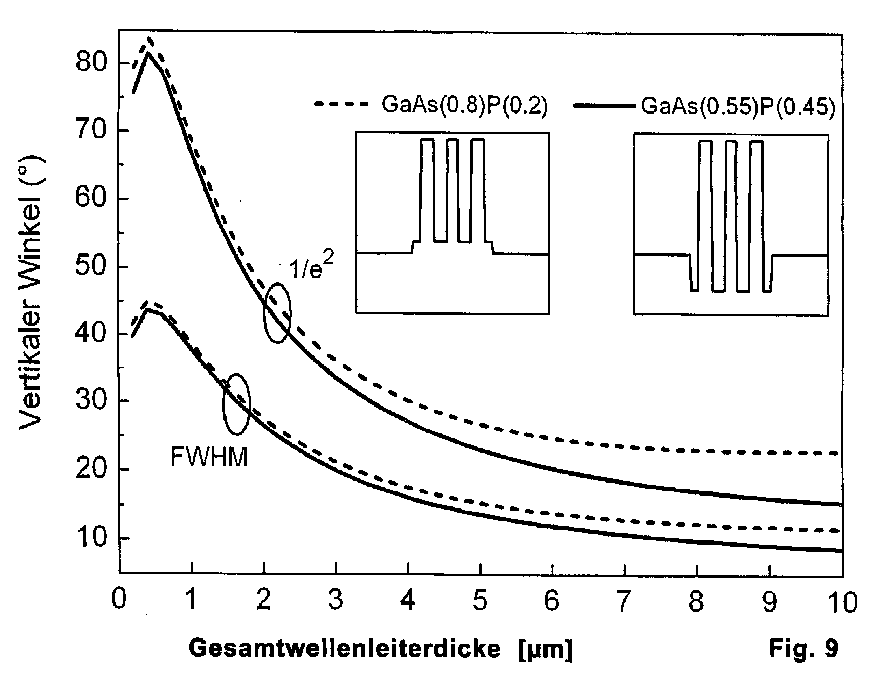

Fig. 9 zeigt die Abhängigkeit der Fernfelddivergenz von der Gesamtwellenleiterdicke für eine herkömmliche Quantentrogstruktur und eine erfindungsgemäße Quantentrogstruktur. Es ist zu erkennen, dass die Fernfelddivergenz für erfindungsgemäße Quantentrogstrukturen (bei denen die Barriereschichten eine Brechzahl aufweisen, die kleiner oder gleich als die Brechzahl der jeweils angrenzenden Wellenleiterschicht ist, hier gekennzeichnet durch die durchgezogene Linie für GaAs(0.55)P(0.45)) erst für relativ dicke Gesamtwellenleiterdicken ab 2 µm deutlich geringer als die Fernfelddivergenz für herkömmliche Quantentrogstrukturen (gestrichelte Linie) ist. Ein Optimum zwischen geringer Fernfelddivergenz und geringem Bahnwiderstand ergibt sich zwischen 2 und 6 µm Gesamtwellenleiterdicke, insbesondere für asymmetrische Wellenleiter.

### Bezugszeichen liste

- 10: aktive Schicht
- 12: erste Wellenleiterschicht
- 14: erste Mantelschicht
- 16: zweite Wellenleiterschicht
- 18: zweite Mantelschicht
- 20: Topfschicht
- 22: Barriereschicht
- 22a: der ersten Weflenfeiterschicht nächstgelegene Barriereschicht
- 22b: der zweiten Wellenleiterschicht nächstgelegene Barriereschicht
- 24: Schulter
- 100: Rippenwellenleiter
- 102: Restschichtdicke

## Patentansprüche

1. Optoelektronisches Halbleiterbauelement, aufweisend:
eine aktive Schicht (10), die zur Strahlungserzeugung geeignet ist, eine erste Wellenleiterschicht (12), die auf einer ersten Seite der aktiven Schicht (10) angeordnet ist, eine erste Mantelschicht (14), die auf der ersten Wellenleiterschicht (12) angeordnet ist, eine zweite Wellenleiterschicht (16), die auf einer zweiten Seite der aktiven Schicht (10) angeordnet ist, und eine zweite Mantelschicht (18), die auf der zweiten Wellenleiterschicht (16) angeordnet ist,
wobei die aktive Schicht (10) eine Quantentopfstruktur aufweist, bei der mindestens eine Topfschicht (20) und mindestens zwei Barriereschichten (22) abwechselnd aufeinander geschichtet sind,
wobei
die Summe der Dicke der ersten Wellenleiterschicht (12) und der zweiten Wellenleiterschicht (16) größer als 2 µm beträgt, **dadurch gekennzeichnet, dass** die jeweils der ersten Wellenleiterschicht (12) und der zweiten Wellenleiterschicht (16) nächstgelegenen Barriereschichten (22a, 22b) eine Brechzahl aufweisen, die kleiner oder gleich als die Brechzahl der jeweils angrenzenden Wellenleiterschicht (12, 16) ist.

2. Halbleiterbauelement nach Anspruch 1,
**dadurch gekennzeichnet, dass**
die Summe der Dicke der ersten Wellenleiterschicht (12) und der zweiten Wellenleiterschicht (16) größer als 4 µm.

3. Halbleiterbauelement nach einem der vorhergehenden Ansprüche,
**dadurch gekennzeichnet, dass**
die Dicke der ersten Wellenleiterschicht (12) größer als die Dicke der zweiten Wellenleiterschicht (16) ist.

4. Halbleiterbauelement nach Anspruch 3,
**dadurch gekennzeichnet, dass**
das Verhältnis der Dicke der ersten Wellenleiterschicht (12) zur Dicke der zweiten Wellenleiterschicht (16) zwischen 1.5 und 10, bevorzugt zwischen 2 und 5 beträgt.

5. Halbleiterbauelement nach einem der vorhergehenden Ansprüche,
**dadurch gekennzeichnet, dass**
ein Rippenwellenleiter (100) im Bereich der zweiten Wellenleiterschicht (16) und der zweiten Mantelschicht (18) vorgesehen ist.

6. Halbleiterbauelement nach Anspruch 5,
**dadurch gekennzeichnet, dass**
die Breite des Rippenwellenleiters (100) größer 2 µm, bevorzugt größer als 4 µm beträgt.

7. Halbleiterbauelement nach einem der vorhergehenden Ansprüche,
**dadurch gekennzeichnet, dass**
alle Barriereschichten (22, 22a, 22b) eine Brechzahl aufweisen, die kleiner oder gleich als die Brechzahl der jeweils angrenzenden Wellenleiterschicht (12, 16) ist.

8. Halbleiterbauelement nach einem der vorhergehenden Ansprüche,
**dadurch gekennzeichnet, dass**
die jeweils der ersten Wellenleiterschicht (12) und/oder der zweiten Wellenleiterschicht (16) nächstgelegenen Barriereschichten (22a, 22b) eine Schichtdicke von kleiner als 12 nm aufweisen.

9. Halbleiterbauelement nach einem der vorhergehenden Ansprüche,
**dadurch gekennzeichnet, dass**
sämtliche Topfschichten (20) der Quantentopfstruktur die gleiche Brechzahl und/oder die gleiche Dicke aufweisen.

10. Halbleiterbauelement nach einem der vorhergehenden Ansprüche,
**dadurch gekennzeichnet, dass**
sämtliche Barriereschichten (22) der Quantentopfstruktur die gleiche Brechzahl und/oder die gleiche Dicke aufweisen.

11. Halbleiterbauelement nach einem der vorhergehenden Ansprüche,
**dadurch gekennzeichnet, dass**
die Differenz zwischen der Brechzahl der ersten Wellenleiterschicht (12) und der nächstgelegenen Barriereschicht (22a) zwischen +0.01 und +0.4 beträgt und/oder die Differenz zwischen der zweiten Wellenleiterschicht (16) und der nächstgelegenen Barriereschicht (22b) zwischen +0.01 und +0.4 beträgt.

12. Halbleiterbauelement nach einem der vorhergehenden Ansprüche,
**dadurch gekennzeichnet, dass**
die Topfschicht (20) und/oder die Barriereschichten (22) einen Verbindungshalbleiter mit dem Element Phosphor oder Aluminium enthält, wobei der Phosphorgehalt der mindestens einen Topfschicht (20) geringer als der Phosphorgehalt der mindestens zwei Barriereschichten (22) ist.

13. Halbleiterbauelement nach Anspruch 12,
**dadurch gekennzeichnet, dass**
der Unterschied in den Elementanteilen der mindestens zwei Barriereschichten (22) größer als 0.2 ist.

14. Halbleiterbauelement nach einem der vorhergehenden Ansprüche,
**dadurch gekennzeichnet, dass**
die Brechzahl der Wellenleiterschichten (12, 16) uniform ist und/oder die Brechzahl der Mantelschichten (14, 18) uniform ist.

15. Halbleiterbauelement nach einem der Ansprüche 5 bis 14,
**dadurch gekennzeichnet, dass**
die Breite des Rippenwellenleiters in Abhängigkeit von der Dicke der Wellenleiterschichten gewählt ist.

## Claims

1. An optoelectronic semiconductor element, comprising:
an active layer (10) which is suitable for generating radiation, a first waveguide layer (12) which is arranged on a first side of the active layer (10), a first cladding layer (14) which is arranged on the first waveguide layer (12), a second waveguide layer (16) which is arranged on a second side of the active layer (10), and a second cladding layer (18) which is arranged on the second waveguide layer (16), wherein the active layer (10) has a quantum well structure, in which at least one well layer (20) and at least two barrier layers (22) are arranged in alternating layers,
wherein the sum of the thickness of the first waveguide layer (12) and the second waveguide layer (16) is greater than 2 µm,
**characterized in that**
the barrier layers (22a, 22b) nearest in each case to the first waveguide layer (12) and the second waveguide layer (16) have a refractive index which is less than or equal to the refractive index of the adjacent waveguide layer (12, 16) in each case.

2. The semiconductor element according to Claim 1,
**characterized in that**
the sum of the thickness of the first waveguide layer (12) and the second waveguide layer (16) is greater than 4 µm.

3. The semiconductor element according to any one of the preceding claims,
**characterized in that**
the thickness of the first waveguide layer (12) is greater than the thickness of the second waveguide layer (16).

4. The semiconductor element according to Claim 3,
**characterized in that**
the ratio of the thickness of the first waveguide layer (12) to the thickness of the second waveguide layer (16) is between 1.5 and 10, preferably between 2 and 5.

5. The semiconductor element according to any one of the preceding claims,
**characterized in that**
a ribbed waveguide (100) is provided in the area of the second waveguide layer (16) and the second cladding layer (18).

6. The semiconductor element according to Claim 5,
**characterized in that**
the width of the ribbed waveguide (100) is greater than 2 µm, preferably greater than 4 µm.

7. The semiconductor element according to any one of the preceding claims,
**characterized in that**
all of the barrier layers (22, 22a, 22b) have a refractive index, which is less than or equal to the refractive index of the adjacent waveguide layer (12, 16) in each case.

8. The semiconductor element according to any one of the preceding claims,
**characterized in that**
the barrier layers (22a, 22b) nearest in each case to the first waveguide layer (12) and/or the second waveguide layer (16) have a layer thickness of less than 12 nm.

9. The semiconductor element according to any one of the preceding claims,
**characterized in that**
all of the well layers (20) of the quantum well structure have the same refractive index and/or the same thickness.

10. The semiconductor element according to any one of the preceding claims,
**characterized in that**
all of the barrier layers (22) of the quantum well structure have the same refractive index and/or the same thickness.

11. The semiconductor element according to any one of the preceding claims,
**characterized in that**
the difference between the refractive index of the first waveguide layer (12) and the nearest barrier layer (22a) is between +0.01 and +0.4 and/or the difference between the second waveguide layer (16) and the nearest barrier layer (22b) is between +0.01 and +0.4.

12. The semiconductor element according to any one of the preceding claims,
**characterized in that**
the well layer (20) and/or the barrier layers (22) include(s) a connecting semiconductor with the element phosphorus or aluminum, whereby the phosphorus content of the at least one well layer (20) is less than the phosphorus content of the at least two barrier layers (22).

13. The semiconductor element according to claim 12,
**characterized in that**
the difference in the element proportions of the at least two barrier layers (22) is greater than 0.2.

14. The semiconductor element according to any one of the preceding claims,
**characterized in that**
the refractive index of the waveguide layers (12, 16) is uniform and/or the refractive index of the cladding layers (14, 18) is uniform.

15. The semiconductor element according to any one of Claims 5 to 14,
**characterized in that**
the width of the ribbed waveguide is selected as a function of the thickness of the waveguide layers.

## Revendications

1. Composant semi-conducteur optoélectronique, présentant :
une couche active (10), qui est appropriée pour la production d'un rayonnement, une première couche de guide d'ondes (12), qui est disposée sur un premier côté de la couche active (10), une première couche d'enveloppe (14), qui est disposée sur la première couche de guide d'ondes (12), une deuxième couche de guide d'ondes (16) qui est disposée sur un deuxième côté de la couche active (10), et une deuxième couche d'enveloppe (18) qui est disposée sur la deuxième couche de guide d'ondes (16), la couche active (10) présentant une structure de puits quantique dans laquelle au moins une couche de puits (20) et au moins deux couches barrières (22) sont empilées les unes sur les autres de façon alternée,
la somme de l'épaisseur de la première couche de guide d'ondes (12) et de la deuxième couche de guide d'ondes (16) étant supérieure à 2 µm,
**caractérisé en ce que**
les couches barrières (22a, 22b) respectivement les plus proches de la première couche de guide d'ondes (12) et de la deuxième couche de guide d'ondes (16) présentent un indice de réfraction qui est inférieur ou égal à l'indice de réfraction de la première couche de guide d'ondes (12, 16) respectivement adjacente.

2. Composant semi-conducteur selon la revendication 1,
**caractérisé en ce que**
la somme de l'épaisseur de la première couche de guide d'ondes (12) et de la deuxième couche de guide d'ondes (16) est supérieure à 4 µm.

3. Composant semi-conducteur selon une des revendications précédentes,
**caractérisé en ce que**
l'épaisseur de la première couche de guide d'ondes (12) est supérieure à l'épaisseur de la deuxième couche de guide d'ondes (16).

4. Composant semi-conducteur selon la revendication 3,
**caractérisé en ce que**
le rapport de l'épaisseur de la première couche de guide d'ondes (12) à l'épaisseur de la deuxième couche de guide d'ondes (16) est compris entre 1,5 et 10, de préférence entre 2 et 5.

5. Composant semi-conducteur selon une des revendications précédentes,
**caractérisé en ce**
**qu'**il est prévu un guide d'ondes nervuré (100) dans la zone de la deuxième couche de guide d'ondes (16) et de la deuxième couche d'enveloppe (18).

6. Composant semi-conducteur selon la revendication 5,
**caractérisé en ce que**
la largeur du guide d'ondes nervuré (100) est supérieure à 2 µm, de préférence supérieure à 4 µm.

7. Composant semi-conducteur selon une des revendications précédentes,
**caractérisé en ce que**
toutes les couches barrières (22, 22a, 22b) présentent un indice de réfraction qui est inférieur ou égal à l'indice de réfraction de la couche de guide d'ondes (12, 16) respectivement adjacente.

8. Composant semi-conducteur selon une des revendications précédentes,
**caractérisé en ce que**
les couches barrières (22a, 22b) respectivement les plus proches de la première couche de guide d'ondes (12) et/ou de la deuxième couche de guide d'ondes (16) présentent une épaisseur de couche inférieure à 12 nm.

9. Composant semi-conducteur selon une des revendications précédentes,
**caractérisé en ce que**
toutes les couches de puits (20) de la structure de puits quantique présentent le même indice de réfraction et/ou la même épaisseur.

10. Composant semi-conducteur selon une des revendications précédentes,
**caractérisé en ce que**
toutes les couches barrières (22) de la structure de puits quantique présentent le même indice de réfraction et/ou la même épaisseur.

11. Composant semi-conducteur selon une des revendications précédentes,
**caractérisé en ce que**
la différence entre l'indice de réfraction de la première couche de guide d'ondes (12) et de la couche barrière (22a) la plus proche est comprise entre +0,01 et +0,4 et/ou **en ce que** la différence entre la deuxième couche de guide d'ondes (16) et la couche barrière (22b) la plus proche est comprise entre +0,01 et +0,4.

12. Composant semi-conducteur selon une des revendications précédentes,
**caractérisé en ce que**
la couche de puits (20) et/ou les couches barrières (22) contiennent un semi-conducteur composé avec l'élément phosphore ou aluminium, la teneur en phosphore de la couche de puits (20) au moins au nombre de un étant plus faible que la teneur en phosphore des couches barrières (22) au moins au nombre de deux.

13. Composant semi-conducteur selon la revendication 12,
**caractérisé en ce que**
la différence dans les proportions d'éléments des couches barrières (22) au moins au nombre de deux est supérieure à 0,2.

14. Composant semi-conducteur selon une des revendications précédentes,
**caractérisé en ce que**
l'indice de réfraction des couches de guide d'ondes (12, 16) est uniforme et/ou en ce que l'indice de réfraction des couches d'enveloppe (14, 18) est uniforme.

15. Composant semi-conducteur selon une des revendications 5 à 14,
**caractérisé en ce que**
la largeur du guide d'ondes nervuré est choisie en fonction de l'épaisseur des couches de guide d'ondes.
